# EUROPEAN PATENT APPLICATION

(11) **EP 1 249 338 A2**
(43) Date of publication of application: **16.10.2002**
(21) Application number: 02007936.4
(22) Date of filing: 09.04.2002
(51) Int. Cl.: B32B 27/08, H01L 31/048

(54) **Outer covering for solar battery**

(30) Priority: 12.04.2001 JP 2001113716
(71) Applicant: Sumitomo Chemical Company, Limited, Chuo-ku Osaka 541-8550 (JP)
(72) Inventor: Yamaguchi, Takanari, Tsukuba-shi, Ibaraki (JP); Kumada, Hiroaki, Inashiki-gun, Ibaraki (JP)
(74) Representative: Henkel, Feiler, Hänzel

(57) **Abstract**

Provided is an outer covering for solar battery, comprising a resin laminate having a liquid crystal polymer layer showing optical anisotropy in molten state, which has excellent water vapor-barrier property and imparts durability to the solar battery.

## Description

### BACKGROUND OF THE INVENTION

### Field of the Invention

The present invention relates to an outer covering for solar battery, more particularly, an outer covering for solar battery having excellent water vapor-barrier property and imparting durability to a solar battery.

### Description of the Related Art

Recently, urgent consideration is required on energy sources of fossil fuels such as coal, petroleum, natural gas and the like from the standpoint of exhaustion of resources and the standpoint of environmental problems by combustion gases. Solar energy is actively used as an effective means for solving these problems, and there is a significant expectation for solar batteries. Particularly, thin flexible solar batteries can be applied in wider fields such as clock, electronic calculator, individual housing and street lamp uses and the like. Such thin solar batteries are often formed of a laminate composed of a substrate made of a resin film, glass, metal plate and the like; a power generation element made of single crystal silicon, polycrystal silicon, a single crystal compound such as amorphous silicon or gallium arsenate, a polycrystal compound of cadmium sulfide and the like, etc.; and a transparent conductive inorganic material film, in general.

Recently, methods of further reducing the thickness of a solar battery have been contrived, and thin film amorphous silicon is frequently used as a power generation element. Further, there are recently also suggested methods of using a resin film as a substrate to decrease the thickness of the substrate and molding batteries into various shapes and allowing batteries to have flexibility, and for example, a solar battery using a polyimide, PET, PEN, acrylic resin film and the like as a substrate has been suggested (JP-A No. 9-148606). However, when such a resin film is used as a substrate of a solar battery, there is a problem pointed out such as corrosion of an electrode and the like and deterioration of a solar battery itself, leading to decrease in durability thereof, because of insufficient water vapor-barrier property and the like.

On the other hand, also suggested is a solar battery apparatus coated with a PET film, obtained by sandwiching a solar battery with EVA (ethylene/vinyl acetate copolymer) films for sealing and coating this sealed resin layer with PVF (polyvinyl fluoride) as a waterproof film (JP-A No. 9-18042).

However, though such an outer covering for solar battery composed of PVF and PET manifest a waterproof effect, moistureproof is not satisfactory sufficiently.

### SUMMARY OF THE INVENTION

The present inventors have intensively continued investigation for finding an outer covering for solar battery manifesting a sufficiently satisfactory waterproof effect and also moistureproof effect, , and resultantly found that a resin laminate having a specific resin layer such as a liquid crystal polymer showing optical anisotropy in molten state manifests a sufficient moistureproof effect, as an outer covering, leading to completion of the present invention.

Namely, the present invention provides an outer covering for solar battery, comprising a resin laminate having a liquid crystal polymer layer showing optical anisotropy in molten state.

### BRIEF DESCRIPTION OF THE DRAWING

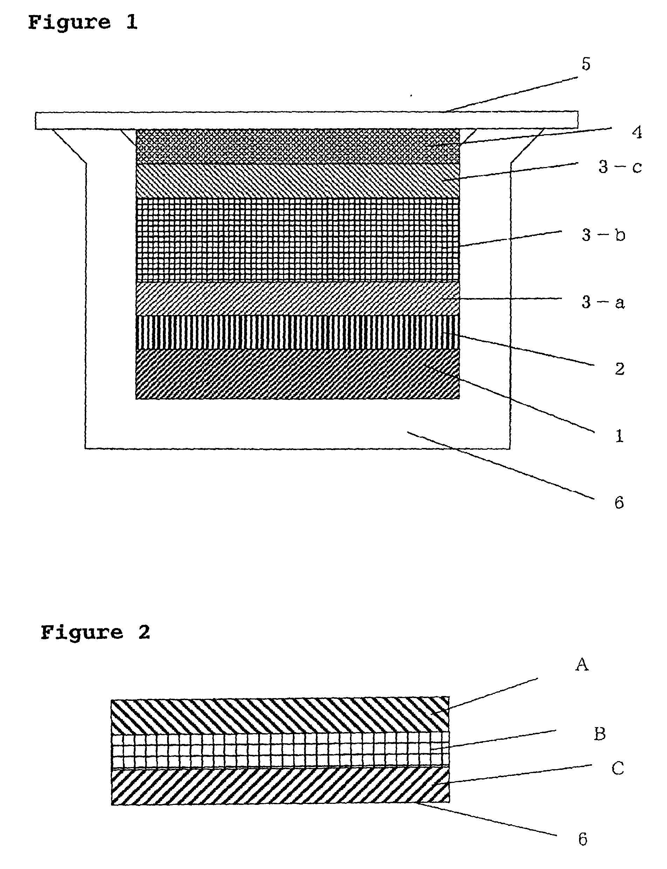

Fig. 1 is a schematic sectional view showing one embodiment of a solar battery equipped with an outer covering of the present invention composed of a resin laminate.

Fig. 2 is a schematic sectional view showing one specific example of a resin laminate in the present invention.

The denotations used in the figures are as follows.
1: Substrate
2: Conductive layer (electrode)
3: Amorphous silicon
3-a: P type
3-b: N type
3-c: I type
4: Transparent electrode
5: Antireflection layer
6: Outer covering composed of resin film laminate containing liquid crystal polymer film
A: Resin layer (EVA, LLDPE, CPP and the like) which can be adhered by heat melting
B: Liquid crystal polymer showing optical anisotropy in molten state
C: Water-repellent resin or surface protective layer (PVdF, PET, surface coating material and the like)

### DETAILED DESCRIPTION OF THE INVENTION

In the present invention, the structure of a solar battery is not particularly restricted, and the basic structure is constituted of components essential for power generation by light such as a transparent electrode, power generation element and substrate. Hereinafter, this constitution is sometimes called a solar battery cell. A take out electrode for taking out electricity generated or a collector can also be mounted outside of a transparent electrode.

As the transparent electrode in the present invention, known transparent electrodes can be used. For example, those obtained by laminating conductive inorganic material layers by a known chemical vapor deposition method, sputtering method and the like are listed. Here, as the inorganic material, metals such as aluminum, gold, silver, copper and the like, and oxide semiconductors such as ITO and the like obtained by adding Sn to In₂O₃, SnO₃, ZnO, In₂O₃ and the like, are listed. In such cases, the thickness of an electrode for ensuring transparency is usually from about 20 to 1000 nm, and further, a transparent antireflection film and a protective film can also be provided on the surface of the electrode.

As the power generation element, known materials can be used, and IV group semiconductors, compound semiconductors, organic semiconductors, TiO₂, GaAs and the like obtained by a wet method, and the like are listed, and of IV group semiconductors, amorphous silicon films, polycyrstal silicon and polycrystal compounds are preferably used. Here, the method of producing an amorphous silicon film is not particularly restricted, and an amorphous silicon film can be obtained by known methods. For example, a glow discharge method in which SiH₄ is decomposed in plasma generated by glow discharge, a reactive sputtering method in which voltage is applied between electrodes placed in argon of low pressure to cause electric discharge, and a target placed on one electrode is sputtered to give rise to deposition of a silicon film on a substrate placed on another electrode, an ion-plating method in which solid silicon is vapor-deposited by electron beam in vacuum, this is introduced in plasma formed in a vacuum vessel to be ionized and simultaneously to cause a reaction with hydrogen, and voltage is applied to cause deposition of ion particles toward the substrate direction, a cluster ion beam method in which amass of coagulated atoms in vacuum is ionized by collision with electron and accelerated to cause deposition on a substrate, and other methods are listed.

The polycrystal silicon can be obtained by a known method. For example, a hydride, halide or hydrogen halide of silicon or the like can be subjected to zinc reduction, hydrogen reduction or thermal decomposition to form a polycrystalline silicon layer on a substrate. Examples of the compound polycrystal layer include layers of CdS-based, CdTe-based, CuIn-based and Se-based compounds and the like, and these can be obtained by known methods such as, for example, a chemical vapor deposition method and the like.

Of the above-mentioned power generation elements, amorphous silicon can be particularly preferably used since it can be molded into a thin film and operates relatively successively even under a fluorescent lamp.

Also regarding the substrate, well-known substrates can be used, and for example, a metal, glass, resin film and the like can be used. When glass or resin film is used, it is preferable that an electric conductive layer is laminated on the power generation element side. Such an electric conductive layer is not particularly restricted, and plates of metals such as aluminum, gold, silver, copper and the like, thin film, and oxide semiconductors such as ITO and the like obtained by adding Sn to In₂O₃, SnO₃, ZnO and In₂O₃, are listed. These may be those obtained by lamination on glass or resin film by a chemical vapor deposition method, sputtering method, vapor deposition method and the like, or may be those obtained by pasting a metal plate or thin film directly on glass or resin film.

The outer covering in the present invention protects a solar battery cell as described above, and characterized in that it is composed of a resin laminate having a liquid crystal polymer layer showing optical anisotropy in molten state.

Such a resin laminate is not particularly restricted providing it contains a layer made of a liquid crystal polymer showing optical anisotropy in molten state, however, it may also be permissible that a resin layer as sealant which can show melt adhesion with heat such as LLDPE, CPP (non-drawn propylene), EVA (ethylene/vinyl acetate copolymer) and the like is laminated on the side corresponding to a substrate in a solar battery, for adhesion to the solar battery cell. Of them, EVA is particularly preferable because of not only a function as an adhesive layer but also excellent cushioning property against impact. Further, LLDPE, CPPPE and the like typically including EVA may also be copolymers of glycidyl methacrylate (GMA), methyl methacrylate (MMA), maleic anhydride (MAH) and the like, for the purpose of improving adhesion.

For the purpose of protecting a layer made of a liquid crystal polymer, a resin film of PET, OPP and the like may be laminated on the side opposite to the side to be contacted with a solar battery cell, or, top coating may be performed with an unsaturated ester and the like. Further, in the case of use under high temperature and high humidity, and the like, it is preferable to use a film made of PVDF excellent in water repellency on the side opposite to the side to be contacted with a solar battery cell. The resin laminate preferably has a constitution of EVA/LCP/PVDF from the contact side with a solar battery cell, in this order.

The resin laminate has a water vapor permeability of preferably 1 g/m²·24 hr or less, more preferably 0.6 g/m²· 24 hr or less, further preferably 0.3 g/m²·24 hr or less. When the water vapor permeability is over 1 g/m²·24 hr, there occurs an unpreferable tendency that water vapor deteriorates a solar battery cell in use of a solar battery, to decrease an ability as the battery. It is particularly preferable when the water vapor permeability of a layer single body made of a liquid crystal polymer is 1 g/m²·24 hr or less, since then there are enlarged alternatives for selecting a resin having other functions such as adhesion, flexibility, oxygen permeability and the like, as the other resin layer in a laminate (the value of 1.0 g or less as a laminate includes a case of 1.0 g resulted from lamination with others even if the value of LCP is 1.1 g for example).

There is no particular restriction on the method of forming layers in a resin laminate, and well-known method such as, for example, co-extrusion, melt lamination, pasting of a sheet or film, and the like, can be adopted. Regarding a layer made of a liquid crystal polymer, there is preferably used a method of molding previously into a film shape before lamination with other resin, since it may be difficult to co-extrude with other resin when the molding temperature is over 300°C for example. As the adhesive in pasting, well-known adhesives can be used. As the pasting film in this case, those of various forms such as ribbon, continuous film, cut film of A4 size and the like, roll winding a film, and the like, can be used. Further, for the purpose of improving the adhesion of the surface of each resin, those subjected to surface treatments such as corona treatment and the like can also be used.

Various liquid crystal polymers are known showing optical anisotropy in molten state, used in the present invention, and for example, whole aromatic polyesters, polyimides, polyesteramides and the like, and resin compositions containing these, are listed. In the present invention, a liquid crystal polyester or a composition containing a liquid crystal polyester is preferable as this liquid crystal polymer, and from the standpoints of molding processability and functions of the resulted film, it is further preferable, in the present invention, to use a liquid crystal polyester resin composition comprising a liquid crystal polyester (A), as a continuous phase and a copolymer (B) containing a functional group reactive with the liquid crystal polyester, as a dispersed phase.

The liquid crystal polyester used in the present invention is a polyester called "thermotropic liquid crystal polymer". More specifically, examples thereof include:
(1) those comprising a combination of an aromatic dicarboxylic acid, an aromatic diol, and an aromatic hydroxycarboxyic acid;
(2) those comprising a combination of different kinds of aromatic hydroxycarboxylic acids;
(3) those comprising a combination of an aromatic dicarboxylic acid and a nuclear-substituted diol; and
(4) those obtainable by the reaction of a polyester such as polyethylene terephthalate with an aromatic hydroxycarboxylic acid; and preferably forms an anisotropic molten product at a temperature of 400°C or lower. Further, in place of the aromatic dicarboxylic acid, the aromatic diol, or the aromatic hydroxycarboxylic acid, ester derivatives thereof can be used. The aromatic dicarboxylic acid, the aromatic diol, and the aromatic hydroxycarboxylic acid may have a substituent such as a halogen atom, an alkyl group, an aryl group or the like, on the aromatic group.

Examples of repeating units of the liquid crystal polyester include the following (1) repeating unit derived from aromatic dicarboxylic acid, and (2) repeating unit derived from aromatic diol, without being limited thereto.
(1) Repeating unit derived from aromatic dicarboxylic acid : 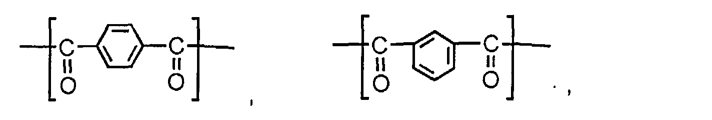 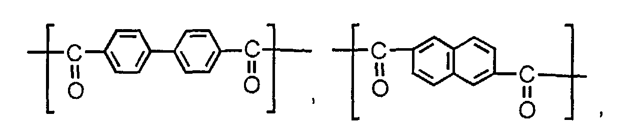 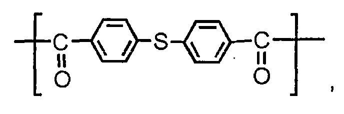 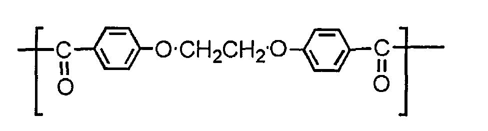
   The aromatic ring in each of the above structural unit may be substituted with a halogen atom, an alkyl group, an aryl group or the like.
(2) Repeating unit derived from an aromatic diol: 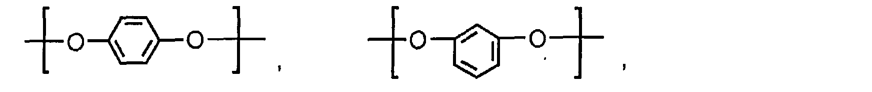 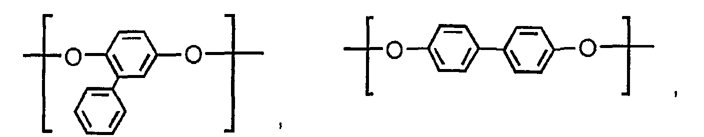 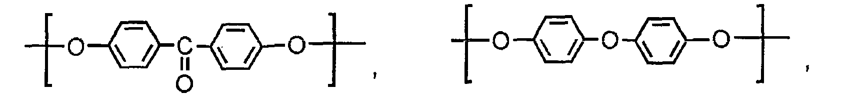 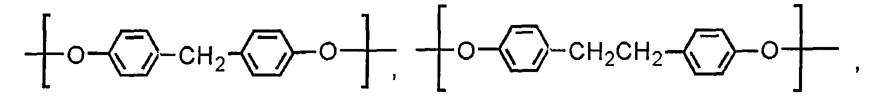 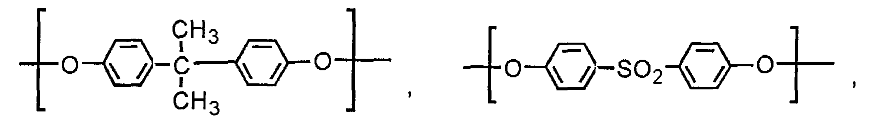 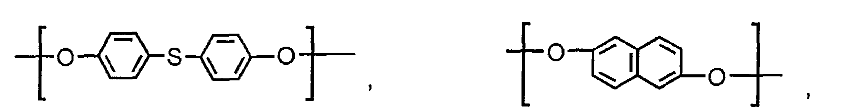 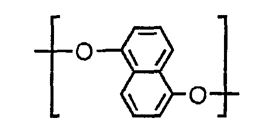
   The aromatic ring in each of the above structural unit may be substituted with a halogen atom, an alkyl group, an aryl group or the like.
(3) Repeating unit derived from an aromatic hydroxycarboxylic acid:

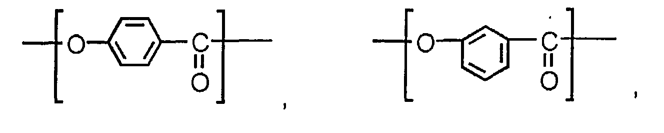

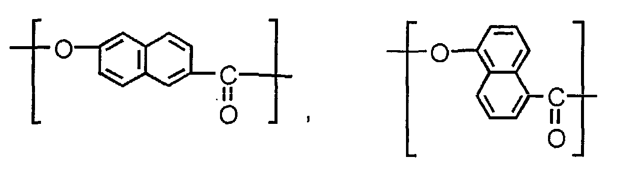

The aromatic ring in each of the above structural unit may be substituted with a halogen atom, an alkyl group, an aryl group or the like.

Liquid crystal polyesters including a repeating unit: 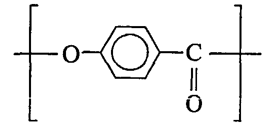 are particularly preferable in heat resistance, mechanical properties, and processability, and those including at least 30 mole % of the repeating unit are further preferable. Specifically, combinations of the repeating units shown as the following (I) - (VI) are suitable. Moreover, the wholly aromatic polyesters other than (IV) is still suitable in view of moisture proof property.

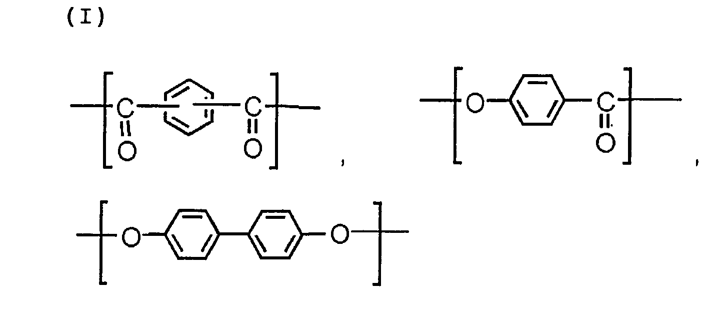

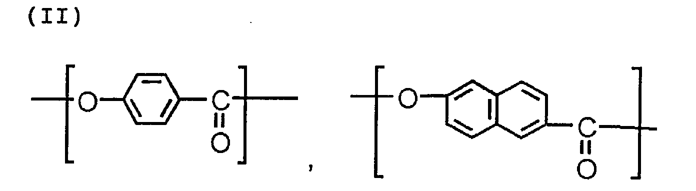

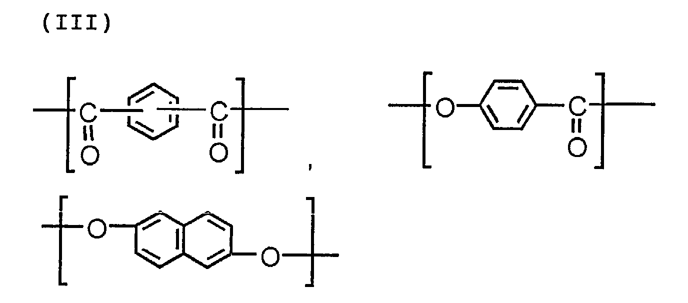

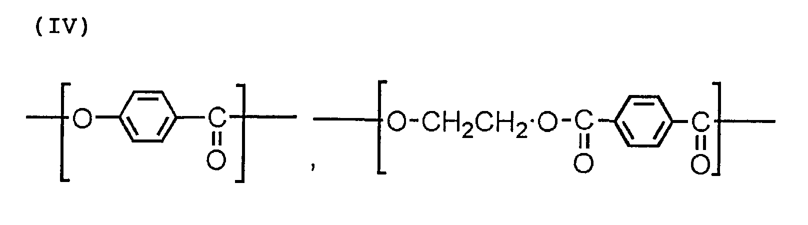

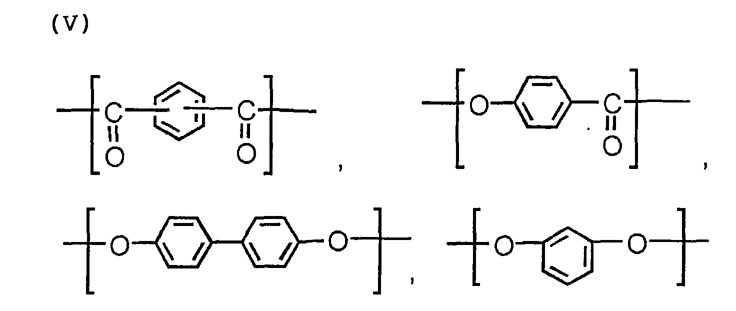

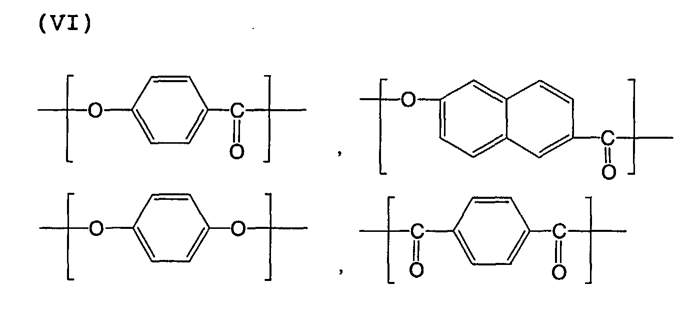

Production method of the above liquid crystal polyesters (I) to (VI) are disclosed in JP-B-47-47870, JP-B-63-3888, JP-B-63-3891, JP-B-56-18016, and JP-A-2-51523. Among these, combinations represented by (I), (II), and (IV) are preferable, and the combinations (I) and (II) are more preferable.

In the present invention, a liquid crystal polyester comprising: 30-80 % by mole of repeating unit (a'); 0-10 % by mole of repeating unit (b'); 10-25 % by mole of repeating unit (c'); and 10-35 % by mole of repeating unit (d'); is preferably used for the field where high heat resistance is required. 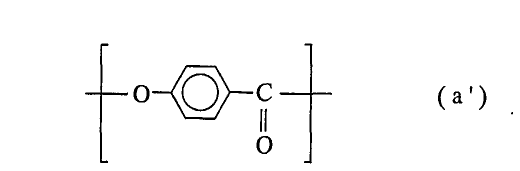 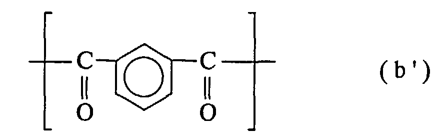 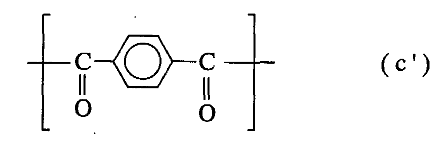 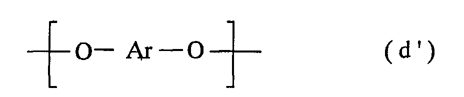 In the formula, Ar is a divalent aromatic group.

As the divalent aromatic group of repeating unit (d'), a divalent aromatic group in the above aromatic diol is suitable, and a wholly aromatic diol is preferable for use where especially high heat resistance is required.

In the outer covering for solar battery of the present invention, from standpoints such as an environmental problem, in the field required for easy abandonment, such as incineration after use, a liquid crystal polyester constituted with the combination of elements of only carbon, hydrogen and oxygen is used especially preferably, among the suitable combinations required for each fields exemplified so far.

In view of moldability of producing a liquid crystal polymer filler from the film, the liquid crystal polyester composition comprising a liquid crystal polyester (A) as a continuous phase and a copolymer (B) containing a functional group reactive with liquid crystal polyester as a dispersed phase.

The component (B) used for the above liquid crystal polyester resin composition is a copolymer having a functional group reactive with liquid crystal polyester. As such a functional group reactive with liquid crystal polyester, any functional groups can be used as long as it has reactivity with a liquid crystal polyester. Concretely, exemplified are an oxazolyl group, an epoxy group, an amino group, etc., and preferably an epoxy group. The epoxy group etc. may exist as a part of other functional groups, and as such an example, a glycidyl group is exemplified.

In the copolymer (B), as a method of introducing such a functional group into a copolymer, it is not limited especially and can be carry out by the well-known methods. For example, It is possible to introduce a monomer having this functional group by copolymerization in a preparation stage of the copolymer. It is also possible to conduct a graft copolymerization of a monomer having this functional group to a copolymer.

Monomers having a functional group reactive with liquid crystal polyester, especially, monomers containing a glycidyl group are used preferably. As the monomers having a functional group reactive with liquid crystal polyester, an unsaturated glycidyl carboxylate and an unsaturated glycidyl ether represented by the general formula 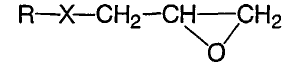 is used suitably.
R is a hydrocarbon group of 2-13 carbons having an ethylenically unsaturated bond, and X is -C(O)O-, -CH₂-O- or

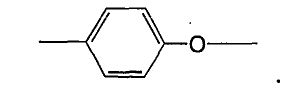

As unsaturated glycidyl carboxylate, exemplified are, for example: glycidyl acrylate, glycidyl methacrylate, itaconic acid diglycidyl ester, butene tri carboxylic acid triglycidyl ester, p-styrene glycidyl carboxylate, etc. As unsaturated glycidyl ether, exemplified are, for example: vinyl glycidyl ether, allyl glycidyl ether, 2-methyl allyl glycidyl ether, methacryl glycidyl ether, styrene-p-glycidyl ether, etc.

As unsaturated glycidyl ether, exemplified are, for example: vinyl glycidyl ether, allyl glycidyl ether, 2-methyl allyl glycidyl ether, methacryl glycidyl ether, styrene-p-glycidyl ether, etc.

The above copolymer (B) having a functional group reactive with liquid crystal polyester, is suitably a copolymer having 0.1 to 30% by weight of a unsaturated glycidyl carboxylate unit and/or a unsaturated glycidyl ether unit.

Suitably, the above copolymer (B) having a functional group reactive with liquid crystal polyester is a copolymer having a heat of fusion of crystal of less than 3J/g. Moreover, as the copolymer (B), Mooney viscosity is suitably 3-70, more suitably 3-30, and especially suitably 4-25.

Here, Mooney viscosity means the value measured at 100 °C using a large rotor according to JIS K6300.

When it is outside the above ranges, heat stability or flexibility of the composition may deteriorate and it is not preferable.

The above copolymer (B) having a functional group reactive with liquid crystal polyester may be either a thermoplastic resin, a rubber or a composition thereof. Preferable is a rubber which give a molded body such as film or sheet, having excellent heat stability and flexibilty.

As a method of introducing such a functional group reactive with a liquid crystal polyester into a rubber, it is not limited especially and can be carry out by the well-known methods. For example, it is possible to introduce a monomer having the functional group by copolymerization in a preparation stage of the rubber. It is also possible to conduct a graft copolymerization of a monomer having the functional group to a rubber.

Concrete examples of the copolymer (B) having a functional group reactive with liquid crystal polyester, as a rubber having epoxy group, include a copolymer rubber of (meth)acrylate-ethylene-(unsaturated glycidyl carboxylate and/or unsaturated glycidyl ether).

Here, the (meth)acrylate is an ester obtained from an acrylic acid or methacrylic acid and an alcohol. As the alcohol, an alcohol having 1-8 carbons is preferable. Concrete examples of the (meth)acrylates include methyl acrylate, methyl methacrylate, n-butyl acrylate, n-butyl methacrylate, tert-butyl acrylate, tert-butyl methacrylate, 2-ethylhexyl acrylate, 2-ethylhexyl methacrylate, etc. The (meth)acrylates can be used alone or as a mixture of two or more therof.

In the copolymer rubber of the present invention, the (meth)acrylate unit is suitably more than 40 and less than 97% by weight, more suitably 45 - 70 % by weight, the ethylene unit is suitably not less than 3% by weight and less than 50% by weight, more suitably 10 - 49 % by weight, and the unsaturated glycidyl ether unit and/or unsaturated glycidyl ether unit is suitably 0.1 - 30 % by weight, more suitably 0.5 - 20 % by weight.

In case of outside the above range, heat stability and mechanical properties of the obtained molded product, such as film or sheet may become insufficient, and it is not preferable.

The copolymer rubber can be prepared by usual methods, for example, bulk polymerization, emulsion polymerization, solution polymerization, etc. using a free radical initiator. Typical polymerization methods are those described in JP-A-48-11388, JP-A-61-127709, etc., and it can be prepared under the existence of a polymerization initiator which generates a free radical, at the pressure of more than 500 kg/cm², and the temperature of 40-300 °C.

Examples of other rubbers which can be used as copolymer (B) include, an acryl rubber having a functional group reactive with liquid crystal polyester, and a block copolymer rubber of vinyl aromatic hydrocarbon compound-conjugated diene compound having a functional group reactive with liquid crystal polyester.

The acryl rubber here is suitably those having at least one monomer as a main component selected from the compound represented by the general formula (1) 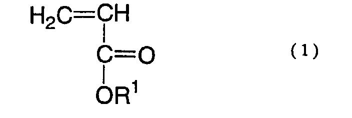 (in the formula, R¹ is an alkyl group or a cyano alkyl group having 1-18 carbon atoms.), the general formula (2) 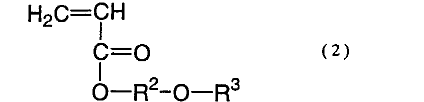 (in the formula, R² is an alkylene group having 1-12 carbon atoms, R³ is an alkyl group having 1-12 carbon atoms.), and the general formula (3) 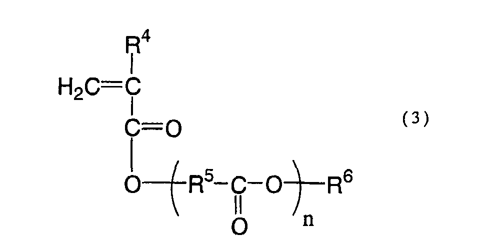 (in the formula, R⁴ is a hydrogen atom or methyl group, R⁵ is an alkylene group having 3-30 carbon atoms, R⁶ is an alkyl group or derivative thereof having 1-20 carbon atoms, and n is an integer of 1-20. )

Concrete examples of the alkyl acrylate represented by the above general formula (1) include, for example, methyl acrylate, ethyl acrylate, propyl acrylate, butyl acrylate, pentyl acrylate, hexyl acrylate, octyl acrylate, 2-ethylhexyl acrylate, nonyl acrylate, decyl acrylate, dodecyl acrylate, cyanoethyl acrylate, etc.

Moreover, examples of the alkoxyalkyl acrylate represented by the above general formula (2) include, for example, methoxy ethyl acrylate, ethoxy ethyl acrylate, butoxy ethyl acrylate, ethoxy propyl acrylate, etc. These can be used alone or in combination of two or more, as a main component of the acryl rubber.

As a composition component of the acryl rubber, an unsaturated monomer which can be copolymerized with at least one monomer selected from the compounds represented by the above general formulas (1) - (3) can be used, according to requirements.

Examples of such unsaturated monomers include styrene, α -methyl styrene, acrylonitrile, halogenated styrene, methacrylonitrile, acryl amide, methacryl amide, vinyl naphthalene, N-methylol acrylamide, vinyl acetate, vinyl chloride, vinylidene chloride, benzyl acrylate, methacrylic acid, itaconic acid, fumaric acid, maleic acid, etc.

The suitable component ratio of the acryl rubber having a functional group reactive with liquid crystal polyester is : 40.0 - 99.9 % by weight of one monomer selected at least from compounds represented by the above general formulas (1) - (3); 0.1 - 30.0 % by weight of unsaturated glycidyl carboxylate and/or unsaturated glycidyl ether; 0.0 - 30.0 % by weight of one monomer which can be copolymerized with the unsaturated monomers selected at least from the compound represented by the above general formula (1) - (3).

If the component ratio of the acryl rubber is within the above range, heat resistance, impact resistance, and mold processing property of the composition are good, and it is preferable.

The preparation process of the acryl rubber is not especially limited, and well known polymerization method described, for example, in JP-A-59-113010, JP-A-62-64809, JP-A-3-160008, or WO 95/04764 can be used. It can be prepared under the existence of a radical initiator, by emulsion polymerization, suspension polymerization, solution polymerization, or the bulk polymerization.

Suitable examples the block copolymer rubber of vinyl aromatic hydrocarbon compound-conjugated diene compound having the above functional group reactive with liquid crystal polyester include: a rubber which is obtained by epoxidization of a block copolymer comprising (a) sequence mainly consisting of vinyl aromatic hydrocarbon compound, and (b) sequence mainly consisting of conjugated diene compound; or a rubber which is obtained by epoxidization of a hydrogenated product of said block copolymer.

Examples of the vinyl aromatic hydrocarbon compound include, for example, styrene, vinyltoluene, divinylbenzene, α-methyl styrene, p-methyl styrene, vinyl naphthalene, etc. Among them, styrene is suitable. Examples of the conjugated diene compound include, for example, butadiene, isoprene, 1,3-pentadiene, 3-butyl-1,3-octadiene, etc. Butadiene and isoprene are suitable.

The block copolymer of vinyl aromatic hydrocarbon compound-conjugated diene compound or the hydrogenated product thereof can be prepared by the well-known methods, for example, as described in JP-B-40-23798, JP-A-59-133203, etc.

As a rubber used as copolymer (B), copolymer rubber of (meth)acrylate-ethylene-(unsaturated glycidylcarboxylate and/or unsaturated glycidylether) is suitably used.

A rubber used as copolymer (B) is vulcanized according to requirements, and it can be used as a vulcanized rubber. Vulcanization of the above copolymer rubber of (meth)acrylate-ethylene-(unsaturated glycidylcarboxylate and/or unsaturated glycidylether) is attained by using a polyfunctional organic carboxylic acid, a polyfunctional amine compound, an imidazole compound, etc., without being limited thereto.

As a concrete example of a copolymer having a functional group reactive with liquid crystal polyester (B), examples of a thermoplastic resin having epoxy group include an epoxy group containing ethylene copolymer comprising: (a) 50 - 99 % by weight of ethylene unit, (b) 0.1 - 30 % by weight of unsaturated glycidylcarboxylate unit and/or unsaturated glycidylether unit, preferably 0.5 - 20 % by weight, and (c) 0 - 50 % by weight of ethylenically unsaturated ester compound unit.

Examples of the ethylenically unsaturated ester compound (c) include vinyl ester of carboxylic acid and alkyl ester of α,β-unsaturated carboxylic acid, etc. such as : vinyl acetate, vinyl propionate, methyl acrylate, ethyl acrylate, butyl acrylate, methyl methacrylate, ethyl methacrylate, and butyl methacrylate. Vinyl acetate, methyl acrylate and ethyl acrylate are especially preferable.

Concrete examples of the epoxy group containing ethylene copolymer include, for example, a copolymer comprising ethylene unit and glycidyl methacrylate unit, a copolymer comprising ethylene unit, glycidyl methacrylate unit and methyl acrylate unit, a copolymer comprising ethylene unit, glycidyl methacrylate unit and ethyl acrylate unit, and a copolymer comprising ethylene unit, glycidyl methacrylate unit and vinyl acetate unit etc.

Melt index (hereinafter referred to as MFR. JIS K6922-2, at 190 °C, 2.16kg load) of the epoxy group containing ethylene copolymer is suitably 0.5-100g/10 minutes, more preferably 2-50g/10 minutes. Although melt index may be outside this range When the melt index is more than 100g/10 minutes, it is not preferable in respect to mechanical physical properties of the composition. When the melt index is less than 0.5 g / 10 minutes, compatibility of component (A) with a liquid crystal polyester is inferior and it is not preferable.

The epoxy group containing ethylene copolymer has suitably a bending shear modulus of 10 - 1300 kg/cm², more suitably 20-1100kg/cm². When the bending shear modulus is outside the range, mold processing property and mechanical properties of the composition may become inadequate.

The epoxy group containing ethylene copolymer is manufactured by high pressure radical polymerization method of copolymerizing usually an unsaturated epoxy compound and ethylene, under existence of a radical generating agent, at a pressure of 500 to 4000 atm and at 100-300 °C, under existence or un-existing of a suitable solvent and a chain transfer agent. It is manufactured also by a method of conducting molten graft copolymerization in an extruder, mixing an unsaturated epoxy compound and a radical generating agent with polyethylene.

The above liquid crystal polyester resin composition is suitably a resin composition comprising (A) a liquid crystal polyester as continuous phase, and (B) a copolymer having a functional group reactive with liquid crystal polyester as dispersed phase. When liquid crystal polyester is not continuous phase, gas barrier property, heat resistance, etc. of a film comprising the liquid crystal polyester resin composition may fall remarkably.

In the resin composition of the copolymer and the liquid crystal polyester having such a functional group, although details of the mechanism are unknown it is thought that a reaction occurs between components (A) and component (B) in the composition, while component (A) forms continuous phase, component (B) disperses minutely, thus the moldability of the composition is improved.

One embodiment of the above liquid crystal polyester resin composition is a resin composition comprising (A) 56.0 - 99.9 % by weight of a liquid crystal polyester, suitably 65.0 - 99.9 % by weight, further suitably 70 - 98 % by weight, (B) 44.0 - 0.1 % by weight of a copolymer having a functional group reactive with liquid crystal polyester, suitably 35.0 - 0.1% by weight, further suitably 30 - 2 % by weight. When component (A) is less than 56.0 % by weight, the water vapor barrier property and heat resistance of the film obtained from the composition may fall. Moreover, when component (A) is more than 99.9 % by weight, the mold processing property of the composition may fall, and the price will become expensive as well.

Well-known method can be used as the method of manufacturing such a liquid crystal polyester resin composition. For example, each component is mixed in a solution state, and then evaporating the solvent, or precipitating it in the solvent. From a industrial standpoint, a method of melt-kneading each component of the above composition in molten state is suitable. For melt-kneading, currently generally used kneading machines such as an extruder having single or twin screws and various kinds of kneaders, can be used. High kneading machine having twin-screw is especially preferable.

In melt-kneading, the setting temperature of the cylinder of kneading machine is suitably in the range of 200-380°C, more suitably 200-360°C, and further more suitably 230-350°C.

In kneading, each component may be mixed uniformly by a machine such as a tumbling mixer or a Henschel mixer beforehand. A method can be used as well, where each component may be quantitatively supplied separately into a kneading machine, with omitting the previous mixing, if necessary.

To the liquid crystal polymer used for the present invention, various kinds of additives such as organic filler, antioxidant, heat stabilizer, light stabilizer, flame retardant, lubricant, antistatic agent, inorganic or organic colorant, rust preventives, crosslinking agent, foaming agent, fluorescent agent, surface smoothing agent, surface gloss improver, release modifiers such as fluoropolymer, etc., can be further added in the manufacturing process, or the subsequent process according to requirements.

The present invention uses the resin laminate as described above having a layer of a liquid crystal polymer, and the liquid crystal polymer is preferably obtained by inflation film formation which can provide simultaneous bi-axial drawing. Namely, the liquid crystal polymer is fed to a melt kneading extruder equipped with a die of annular slit, and melt-kneaded at a cylinder setting temperature of preferably from 200 to 360°C, further preferably from 230 to 350°C. Then, a melted resin is extruded toward upper direction or lower direction from an annular slit of an extruder, to give a cylindrical film (this direction (longitudinal direction) is the MD direction, and a direction crossing this in a film plane is the TD direction). The annular slit interval is usually from 0.1 to 5 mm, preferably from 0.5 to 2 mm, and the diameter of the annular slit is from 20 to 1000 mm, preferably from 50 to 300 mm.

In the inflation molding (film formation), the preferable blow ratio is usually from 1.5 to 10, and the preferable MD drawing magnification is from 1.5 to 40.

When the setting conditions in inflation film formation are out of the above-mentioned ranges; it may be difficult to obtain a film having uniform thickness, containing no wrinkle and having high strength.

The swollen film is taken over passing through nip rolls, after air cooling or water cooling of the periphery.

In inflation film formation, it is possible to select conditions so that a melted body film in the form of cylinder is swollen at uniform thickness to give a smooth surface, depending on properties of a composition.

In other methods than the inflation film formation, a film is not drawn bi-axially and the necessary minimum strength is not obtained, and even if drawn bi-axially sequentially by other method, production thereof needs high cost, in some cases.

The thickness of a film layer made of a liquid crystal polymer showing optical anisotropy in molten state in the present invention is not particularly restricted, however, the thickness is, from the standpoints of water vapor permeability and flexibility, 3 µm or more and less than 500 µm, more preferably 5 µm or more and less than 300 µm, further preferably 8 µm or more and less than 200 µm. When the thickness is less than 3 µm, the water vapor permeability of an outer covering obtained by using this may be over 1.0 g/m²·24 hr, undesirably, and when the thickness is over 500 µm, a possibility of deteriorating flexibility occurs, undesirably.

In the present invention, it may be advantageous that the water vapor permeability of a laminate as an outer covering is 1.0 g/m²·24 hr or less, and the water vapor permeability of a liquid crystal polymer film itself is also preferably 1.0 g/m²·24 hr or less, further preferably 0.8 g/m²·24 hr or less. When the water vapor permeability of a liquid crystal polymer film is 1.0 or more, the constitution of an outer covering may be restricted, undesirably.

In the present invention, surface treatment can be performed previously for improvement in adhesion, on the surface of a film made of a liquid crystal polymer. As such a surface treatment method, for example, corona discharge treatment, plasma treatment, flame treatment, sputtering treatment, solvent treatment, ultraviolet ray treatment, polishing treatment, infrared ray treatment, ozone treatment and the like are listed.

### EXAMPLES

The following examples will described the present invention, but do not limit the scope of the invention.

### (1) Component (A), liquid crystal polymer

(i) 8.3 kg (60 mol) of p-acetoxybenzoic acid, 2.49 kg (15 mol) of terephthalic acid, 0.83 kg (5 mol) of isophthalic acid and 5.45 kg (20.2 mol) of 4,4'-diacetoxydiphenyl were charged in a polymerization vessel equipped with a stirring blade in the form of comb, and the mixture was heated while stirring under a nitrogen gas atmosphere, and polymerized at 330°C for 1 hours. The polymerization was effected under vigorous stirring while liquefying an acetic acid gas by-produced during this operation by a cooling tube and recovering and removing the liquid. Then, the system was cooled gradually, and the resulted polymer at 200°C was removed out of the system. This resulted polymer was ground by a hammer mill manufactured by Hosokawa Micron Corp., to provide particles of 2.5 mm or less. These were further treated at 280°C for 3 hours under a nitrogen gas atmosphere in a rotary kiln, to obtain a whole aromatic polyester in the form of particle having a flow temperature of 324°C, composed of the following repeating structural units.

Here, the flow temperature means a temperature at which the melt viscosity is 48000 poise when a resin heated at a temperature rising rate of 4°C/min is extruded through a nozzle having an internal diameter of 1 mm and a length of 10 mm under a load of 100 kgf/cm² using a flow tester CFT-500 type manufactured by Shimadzu Corp.

Hereinafter, this liquid crystal polyester is abbreviated as A-1. This polymer showed optical anisotropy under pressure at 340°C or more. The repeating structural units of the liquid crystal polyester A-1 are as described below.

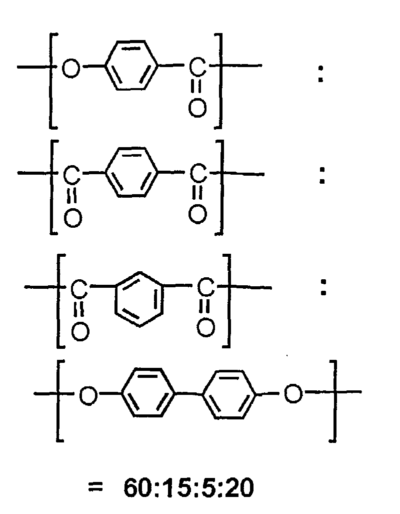

(ii) 16.6 kg (12.1 mol) of p-hydroxybenzoic acid, 8.4 kg (4.5 mol) of 6-hydroxy-2-naphthoic acid and 18.6 kg (18.2 mol) of acetic anhydride were charged in a polymerization vessel equipped with a stirring blade in the form of comb, and the mixture was heated while stirring under a nitrogen gas atmosphere, and polymerized at 320°C for 1 hours, and further, polymerized at 320°C for 1 hours under a reduced pressure of 2.0 torr. Acetic acid by-produced during this operation was distilled out of the system continuously. Then, the system was cooled gradually, and the resulted polymer at 180°C was removed out of the system. This resulted polymer was ground by a hammer mill manufactured by Hosokawa Micron Corp., to provide particles of 2.5 mm or less. These were further treated at 240°C for 5 hours under a nitrogen gas atmosphere in a rotary kiln, to obtain a whole aromatic polyester in the form of particle having a flow initiation temperature of 270°C, composed of the following repeating structural units. Hereinafter, this thermoplastic resin is abbreviated as A-2.

This thermoplastic resin showed optical anisotropy under pressure at 280°C or more, when observed by a polarization microscope. The ratio of repeating structural units of A-2 is as described below.

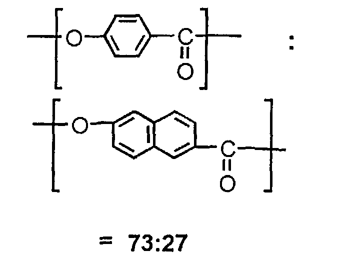

### (2) Component (B)

(i) Rubber of methyl acrylate/ethylene/glycidyl methacrylate = 59.0/38.7/2.3 (ratio by weight), having a Mooney viscosity of 15 and a heat of fusion of a crystal of less than 1 J/g was obtained according to a method described in Example 5 of JP-A No. 61-127709. This rubber may be abbreviated as B-1.

This Mooney viscosity means a value measured by using a large rotor at 100°C according to JIS K6300.

The heat of fusion of a crystal was measured by heating a sample from -150°C to 100°C at a rate of 20°C/min, using DSC.

### (3) Methods of measuring physical property

Measurement was conducted according to the following method, on the resulted film.

(i) Water vapor permeability: It was measured under conditions of a temperature of 40°C and a relative humidity of 95% according to JIS Z0208 (cup method). The unit is g/m²· 24 hr, and the measured value is a value at the thickness of a film used without thickness correction. Reference Example 1

90% by weight of A-1 and 10% by weight of B-1 were melt-kneaded at a cylinder setting temperature of 350°C and a screw revolution of 200 rpm using a twin-screw extruder TEX-30 type manufactured by The Japan Steel Works, Ltd., to obtain a composition. This composition had a flow initiation temperature of 327°C. This composition showed optical anisotropy at 338°C or more.

Pellets of this composition were fed to a single-screw extruder of 60 mmφ equipped with a cylindrical die, and melt-kneaded at a cylinder setting temperature of 350°C and a revolution of 90 rpm, and the melted resin was extruded toward upper direction from a cylindrical die having a diameter of 50 mm, a lip interval of 1.0 mm and a temperature set at 346°C, and in this procedure, dry air was pressed into a hollow part in this cylindrical film to swell the cylindrical film, then, the cylindrical film was cooled and passed through nip rolls to obtain a film.

In this operation, the film showed a blow ratio of 2.3, a draw down ratio of 17.7, and had an average thickness actually measured of 25 µm. This film is sometimes abbreviated as H-1.

H-1 showed a water vapor permeability at 40°C of 0.70 g/m²· 24 hr.

### Reference Example 2

A film having an average thickness actually measured of 50 µm was obtained by the same manner as described above, at a blow ratio of 1.8 and a draw down ratio of 11.2. This film is sometimes abbreviated as H-2.

H-2 showed a water vapor permeability at 40°C of 0.35 g/m²· 24 hr.

### Reference Example 3

95% by weight of A-2 and 5% by weight of B-1 were melt-kneaded at a cylinder setting temperature of 300°C and a screw revolution of 250 rpm using a twin-screw extruder TEX-30 type manufactured by The Japan Steel Works, Ltd., to obtain a composition. This composition showed optical anisotropy at 265°C or more under press. Pellets of this composition were melt-extruded at a cylinder setting temperature of 290°C and a screw revolution of 60 rpm using a single-screw extruder of 60 mmφ equipped with a cylindrical die, and the melted resin was extruded toward upper direction from a cylindrical die having a diameter of 50 mm, a lip interval of 1.0 mm and a temperature set at 305°C, and dry air was pressed into a hollow part in this cylindrical film to swell the cylindrical film, then, the cylindrical film was cooled and passed through nip rolls to obtain a film H-3. The blow ratio was 2.7 and the draw down ratio was 15, and the average thickness actually measured of the film was 25 µm. The water vapor permeability of this film was measured to find it was 0.26 g/m²·24 hr.

### Example 1

5% chloroform solution of B-1 was applied on H-1 obtained in Reference Example 1, dried, then, an LLDPE film having a thickness of 50 µm commercially available was overlapped on the applied surface, and pasted by using heat rolls set at 70°C, to obtain a laminate for outer covering. The water vapor permeability at 40°C was 0.6 g/m²·24 hr.

### Example 2

5% chloroform solution of B-1 was applied on H-1 obtained in Reference Example 1, dried, then, an EVA film having a thickness of 100 µm commercially available was overlapped on the applied surface, and pasted by using heat rolls set at 70°C, to obtain a laminate for outer covering. The water vapor permeability at 40°C was as extremely excellent as 0.6 g/m²· 24 hr.

### Example 3

5% chloroform solution of B-1 was applied on H-2 obtained in Reference Example 2, dried, then, a PVdF film having a thickness of 50 µm commercially available was overlapped on the applied surface, and pasted by using heat rolls set at 70°C. Further, an EVA film having a thickness of 50 µm was overlapped also on another surface of the LCP film, to obtain a laminate for outer covering. The water vapor permeability at 40°C was 0.25 g/m²·24 hr.

### Example 4

5% chloroform solution of B-1 was applied on H-3 obtained in Reference Example 3, dried, then, a PVdF film having a thickness of 50 µm commercially available was overlapped on the applied surface, and pasted by using heat rolls set at 70°C. Further, an EVA film having a thickness of 50 µm was overlapped also on another surface of the LCP film, to obtain a laminate for outer covering. The water vapor permeability at 40°C was 0.18 g/m²·24 hr.

### Comparative Example 1

A resin laminate was obtained in the same manner as in Example 1 except that a PET film having a thickness of 25 µ m commercially available was used in stead of H-1. The water vapor permeability at 40°C was 8.6 g/m²·24 hr.

### Comparative Example 2

A resin laminate was obtained in the same manner as in Example 2 except that a PET film having a thickness of 25 µ m commercially available was used in stead of H-1. The water vapor permeability was 12.2 g/m²·24 hr.

### Comparative Example 3

A resin laminate was obtained in the same manner as in Example 2 except that a PET film having a thickness of 50 µ m commercially available was used in stead of H-2. The water vapor permeability was 1.8 g/m²·24 hr.

### Comparative Example 4

A resin laminate was obtained in the same manner as in Example 3 except that a PET film having a thickness of 25 µ m commercially available was used in stead of H-3. The water vapor permeability was 2.1 g/m²·24 hr.

According to the present invention, an outer covering for solar battery composed of a resin laminate excellent extremely in water vapor barrier property and cheap and flexible can be obtained, it can be used widely in the industry.

## Claims

1. An outer covering for solar battery, comprising a resin laminate having a liquid crystal polymer layer showing optical anisotropy in molten state.

2. The outer covering for solar battery according to Claim 1 wherein the water vapor permeability of the resin laminate is 1.0 g/m²·24 hr or less.

3. The outer covering for solar battery according to Claim 1 or 2 wherein the power generation element in a solar battery cell is amorphous silicon.

4. The outer covering for solar battery according to Claim 3 wherein the resin laminate is placed outside of a substrate in a solar battery cell.

5. The outer covering for solar battery according to Claim 1 wherein the resin laminate further contains a layer made of EVA.

6. The outer covering for solar battery according to Claim 5 wherein the layer made of EVA is placed at the substrate side in a solar battery than a layer made of a liquid crystal polymer.

7. The outer covering for solar battery according to Claim 1 wherein the resin laminate further contains a layer made of PVDF.

8. The outer covering for solar battery according to Claim 1 wherein the liquid crystal polymer showing optical anisotropy in molten state is a liquid crystal polyester.

9. The outer covering for solar battery according to Claim 1 wherein the liquid crystal polymer showing optical anisotropy in molten state is a liquid crystal polyester resin composition comprising a liquid crystal polyester (A), as a continuous phase and a copolymer (B) containing a functional group reactive with the liquid crystal polyester, as a dispersed phase.

10. The outer covering for solar battery according to Claim 9 wherein the liquid crystal polyester resin composition is a composition obtained by melt-kneading 56 to 99.9% by weight of the liquid crystal polyester (A) and 44 to 0.1% by weight of the copolymer (B) containing a functional group reactive with the liquid crystal polyester.

11. The outer covering for solar battery according to Claim 9 wherein the functional group reactive with the liquid crystal polyester is an oxazolyl group, epoxy group or amino group.

12. The outer covering for solar battery according to Claim 9 wherein the copolymer (B) containing a functional group reactive with the liquid crystal polyester is a copolymer containing 0.1 to 30% by weight of an unsaturated glycidyl carboxylate unit and/or unsaturated glycidyl ether unit.

13. The outer covering for solar battery according to Claim 9 wherein the copolymer (B) containing a functional group reactive with the liquid crystal polyester is a copolymer having a heat of fusion of less than 3 J/g.

14. The outer covering for solar battery according to Claim 9 wherein the copolymer (B) containing a functional group reactive with the liquid crystal polyester has a Mooney viscosity in the range from 3 to 70:
the Mooney viscosity herein referred to meaning a value measured by using a large rotor at 100°C according to JIS K6300.

15. The outer covering for solar battery according to Claim 9 wherein the copolymer (B) containing a functional group reactive with the liquid crystal polyester is rubber having an epoxy group.

16. The outer covering for solar battery according to Claim 15 wherein the rubber having an epoxy group is made of (meth)acrylate-ethylene-(unsaturated glycidyl carboxylate and/or unsaturated glycidyl ether)copolymer rubber.

17. The outer covering for solar battery according to Claim 16 wherein the (meth)acrylate includes at least one selected from methyl acrylate, methyl methacrylate, n-butyl acrylate, n-butyl methacrylate, tert-butyl acrylate, tert-butyl methacrylate, 2-ethylhexyl acrylate and 2-ethyl hexyl methacrylate.

18. The outer covering for solar battery according to Claim 9 wherein the copolymer (B) containing a functional group reactive with the liquid crystal polyester is a thermoplastic resin having an epoxy group.

19. The outer covering for solar battery according to Claim 18 wherein the thermoplastic resin having an epoxy group is an epoxy group-containing ethylene copolymer composed of 50 to 99% by weight of an ethylene unit, 0.1 to 30% by weight of an unsaturated glycidyl carboxylate unit and/or an unsaturated glycidyl ether unit and 0 to 50% by weight of an ethylenically unsaturated ester compound unit.

20. The outer covering for solar battery according to Claim 9 wherein the liquid crystal polyester (A) contains the following repeating structural unit in an amount of at least 30 mol% based on the total amount.

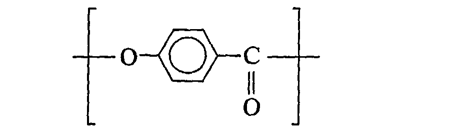

21. The outer covering for solar battery according to Claim 9 wherein the liquid crystal polyester (A) is obtained by reacting an aromatic dicarboxylic acid, aromatic diol and aromatic hydroxycarboxylic acid.

22. The outer covering for solar battery according to Claim 9 wherein the liquid crystal polyester (A) is obtained by reacting a combination of different kinds of aromatic hydroxycarboxylic acids.
